# EUROPEAN PATENT APPLICATION

(11) **EP 3 522 140 A1**
(43) Date of publication of application: **07.08.2019**
(21) Application number: 16917214.5
(22) Date of filing: 29.09.2016
(51) Int. Cl.: G09F 9/30

(54) **ELECTRONIC APPARATUS**

(71) Applicant: Shenzhen Royole Technologies Co., Ltd., Shenzhen, Guangdong 518172 (CN)
(72) Inventor: WU, Dan, Shenzhen Guangdong 518052 (CN); WU, Weifeng, Shenzhen Guangdong 518052 (CN)
(74) Representative: Romano, Giuseppe
(86) International application number: PCT/CN2016/100889
(87) International publication number: WO 2018/058460

(57) **Abstract**

An electronic device (10) includes a flexible display screen (11) and a support frame (12). The support frame (12) includes two annular carriers (122) and a connection mechanism (124) for connecting the two carriers (122). Two ends of the flexible display screen (11) are connected to the two carriers (122) respectively. The carrier (122) includes a reel (1221) and an actuating part (1222), the actuating part (1222) is configured to drive the reel (1221) to wind the flexible display screen (11) when the two carriers (122) gather. The flexible display screen (11) is closed when the two carriers (122) gather and come into contact with each other. The connection mechanism (124) is configured to fix the two carriers (122) when the two carriers (122) separate. The flexible display screen (11) is opened when the two carriers (122) separate. In the electronic device (10), the reel (1221) is driven to wind the flexible display screen (11) by the actuating part (1222), and the flexible display screen (11) is hided in the carrier (122) when a user does not need to use it, thereby having protection effect on the flexible display screen (11).

## Description

### FIELD

The present disclosure relates to a field of wearable smart devices, more particularly to an electronic device.

### BACKGROUND

In recent years, as the intelligent trend of product becomes more and more intense, a smart wearable device, such as a smart watch, a smart wristband, etc., has gradually becomes popular among consumers. The smart wearable device with a display screen can achieve visual operations and clearly display relevant information, thereby greatly facilitating people's lives.

However, in the related art, the display screen of the smart wearable device is generally exposed to the outside and thus easily damaged, and it is easy to accumulate dust or water stain on the display screen over time, which affects the service life of the smart wearable device.

### SUMMARY

The present disclosure seeks to solve at least one of the problems existing in the related art. To this end, the present disclosure provides an electronic device.

The electronic device according to embodiments of the present disclosure includes: a flexible display screen; and a support frame including: two annular carriers, two ends of the flexible display screen being connected to the two carriers respectively, the carrier including a reel and an actuating part, the actuating part being configured to drive the reel to wind the flexible display screen when the two carriers gather, the flexible display screen being closed when the two carriers gather and come into contact with each other; and a connection mechanism for connecting the two carriers, the connection mechanism being configured to fix the two carriers when the two carriers separate, and the flexible display screen being opened when the two carrier separate.

In the electronic device according to embodiments of the present application, the reel is driven to wind the flexible display screen by the actuating part, and the flexible display screen is hided in the carrier when a user does not need to use it, thereby having protection effect on the flexible display screen.

In some embodiments, each carrier includes a surface facing the other carrier, and defines a receiving cavity therein and an opening located in the surface and communicated with the receiving cavity, the flexible display screen passes through the two openings, the reel and the actuating part are received in the receiving cavity, and the two surface are attached to each other when the two carriers gather.

In some embodiments, the electronic device includes a sealing member, the sealing member is disposed in the opening and defines a via hole together with an inner wall of the opening, and the flexible display screen passes through the via hole.

In some embodiments, the sealing member is made of soft materials, and the flexible display screen contact with the sealing member.

In some embodiments, each carrier includes a straight segment, and the flexible display screen is connected to the straight segment.

In some embodiments, the actuating part includes a base fixedly disposed in the carrier and a coil spring connecting the base with the reel, the reel is rotatably disposed to the base, and the coil spring is configured to drive the reel to wind the flexible display screen when the two carriers gather.

In some embodiments, a length of the reel is greater than a length of the flexible display screen.

In some embodiments, the connection mechanism includes: a first hinge; a second hinge and a third hinge both connected to a first end of the first hinge, the second hinge including a first gear, an end of the third hinge being connected to one of the carriers; and a fourth hinge and a fifth hinge both connected to a second end of the first hinge, the fifth hinge including a second gear, an end of the fifth hinge being connected to the other of the carriers; the second hinge and the fifth hinge are connected by engagement between the first gear and the second gear.

In some embodiments, the electronic device includes a sensor and a control device, the sensor is configured to detect that whether the two carriers separate, and the control device is configured to control the flexible display screen to display in full screen when the two carriers separate.

In some embodiments, the sensor includes a photoelectric switch.

In some embodiments, the electronic device includes a battery disposed in the receiving cavity, and the battery is electrically connected to the flexible display screen.

In some embodiments, the electronic device includes a printed circuit board disposed in the receiving cavity, and the flexible display screen is electrically connected to the printed circuit board.

In some embodiments, the first hinge includes a V-shaped baffle, one arm of the V-shaped baffle abuts against an outer side surface of the fifth hinge, and the other arm of the V-shaped baffle abuts against an outer side surface of the third hinge to restrict an open angle of the connection mechanism.

Additional aspects and advantages of embodiments of present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of embodiments of the present disclosure will become apparent and more readily appreciated from the following descriptions made with reference to the drawings, in which:
Fig. 1 illustrates a schematic view showing a process of switching a display state of an electronic device according to an embodiment of the present disclosure.
Fig. 2 illustrates a schematic view of an electronic device in a closed state according to an embodiment of the present disclosure.
Fig. 3 illustrates a schematic view of an electronic device in an opened state according to an embodiment of the present disclosure.
Fig. 4 is a partially exploded view of an electronic device according to an embodiment of the present disclosure.
Fig. 5 is another partially exploded view of an electronic device according to an embodiment of the present disclosure.
Fig. 6 illustrates an exploded view of a connection mechanism according to an embodiment of the present disclosure.
Fig. 7 illustrates a perspective view of a connection mechanism according to an embodiment of the present disclosure.
Fig. 8 illustrates a schematic view of functional modules of an electronic device according to an embodiment of the present disclosure.

### Brief description of reference numerals and main elements:

electronic device 10, flexible display screen 11, support frame 12, carrier 122, reel 1221, actuating part 1222, base 12222, coil spring 12224, surface 1223, receiving cavity 1224, opening 1225, straight segment 1226, connection mechanism 124, first hinge 1241, V-shaped baffle 12412, second hinge 1242, first gear 12422, third hinge 1243, fourth hinge 1244, fifth hinge 1245, second gear 12452, rotary shaft 1246, sealing member 13, via hole 132, sensor 14, control device 15, battery 16, printed circuit board 17.

### DETAILED DESCRIPTION

Embodiments of the present disclosure will be described in detail and examples of the embodiments will be illustrated in the drawings, where same or similar reference numerals are configured to indicate same or similar members or members with same or similar functions.

The embodiments described herein with reference to drawings are explanatory, illustrative, and configured to generally understand the present disclosure. The embodiments shall not be construed to restrict the present disclosure.

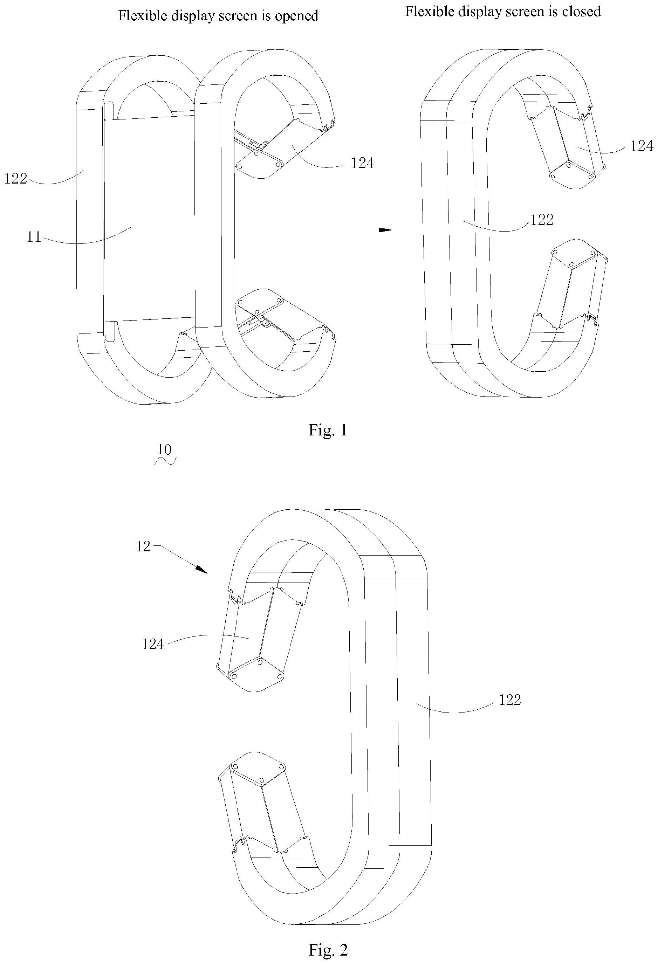

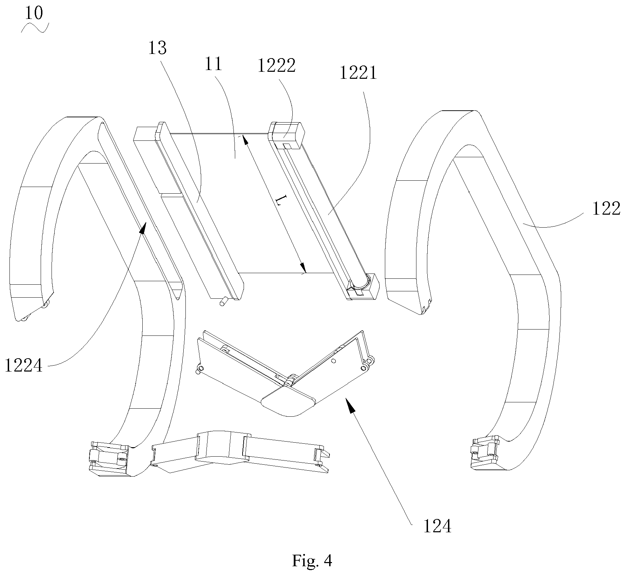

With reference to Figs. 1 to 4, an electronic device 10 according to embodiments of the present disclosure includes a flexible display screen 11, and a support frame 12. The support frame 12 includes two annular carriers 122 and a connection mechanism 124 for connecting the two carriers 122. Two ends of the flexible display screen 11 are connected to the two carriers 122 respectively. The carrier 122 includes a reel 1221 and an actuating part 1222, the actuating part 1222 is configured to drive the reel 1221 to wind the flexible display screen 11 when the two carriers 122 gather, and the flexible display screen 11 is closed when the two carriers 122 gather and come into contact with each other. The connection mechanism 124 is configured to fix the two carriers 122 when the two carriers 122 separate, and the flexible display screen 11 is opened when the two carriers 122 separate.

In the electronic device 10 according to embodiments of the present application, the reel 1221 is driven to wind the flexible display screen 11 by the actuating part 1222, and the flexible display screen 11 is hided in the carrier 122 when a user does not need to use it, thereby having protection effect on the flexible display screen 11.

In some embodiments, the electronic device 10 may be designed in the form of a wristband, which is easy to wear and has advantages of being portable, beautiful, not easy to lose and easy to use.

Certainly, the form of the electronic device 10 is not limited by the above-described embodiments, the electronic device 10 can be designed in other forms in other embodiments according to requirements.

In embodiments of the present disclosure, the actuating part 1222 and the reel 1221 are provided in one of the carriers 122, the flexible display screen 11 has a first end wound on the reel 1221, and the flexible display screen 11 has a second end fixed in the other of carriers 122.

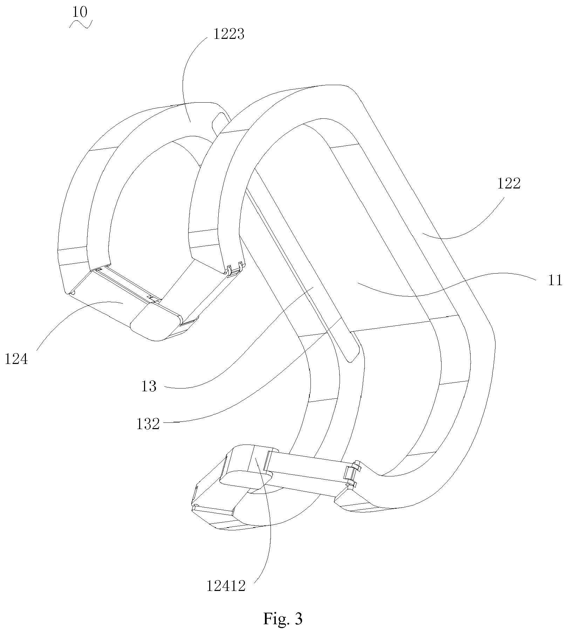

With reference to Figs. 3, 4 and 5, in some embodiments, each carrier 122 includes a surface 1223 facing the other carrier 122, and defines a receiving cavity 1224 therein and an opening 1225 located in the surface 1223 and communicated with the receiving cavity 1224, the flexible display screen 11 passes through the two openings 1225, the reel 1221 and the actuating part 1222 are received in the receiving cavity 1224, and the two surfaces 1223 are attached to each other when the two carriers 122 gather and come into contact with each other.

Specifically, when the two carriers 122 gather and come into contact with each other, the surfaces 1223 of the two carriers 122 are tightly attached to each other, to fully protect the flexible display screen 11.

In some embodiments, the openings 1225 of the two carriers 122 are corresponding and aligned.

That is to say, the two carriers 122 may be symmetrically provided with openings 1225 with the same size, and upper edges and lower edges of the two openings 1225 are flush with one another correspondingly. Thus, the two openings 1225 are easier to form, and the flexible display screen 11 can be substantially located at the same horizontal level, to avoid tilting of the flexible display screen 11.

In some embodiments, the electronic device 10 includes a sealing member 13, the sealing member 13 is provided in the opening 1225 and defines a via hole 132 together with an inner wall of the opening 1225, and the flexible display screen 11 passes through the via hole 132.

Specifically, the sealing member 13 is configured to seal the opening 1225 and leaves the via hole 132, and the via hole 132 is configured to allow the flexible display screen 11 to pass through and to be wound on the reel 1221 sealed in the receiving cavity 1224.

In embodiments of the present disclosure, the flexible display screen 11 has the first end wound on the reel 1221 in one carrier 122, and the flexible display screen 11 has the second end fixed to the sealing member 13 in the other carrier 122, such that the second end of the flexible display screen 11 is fixedly connected to the other carrier 122.

In some embodiments, the via hole 132 may has a size slightly greater than a thickness of the flexible display screen 11, and the flexible display screen 11 may not be in contact with the sealing member 13.

Thus, the flexible display screen 11 may conveniently pass through the via hole 132.

In some embodiments, the sealing member 13 is made of a soft materials, and the flexible display screen 11 is in contact with the sealing member 13.

Thus, the size of the via hole 132 may be set to fit the thickness of the flexible display screen 11. Furthermore, the sealing member 13 is made of a soft material such that abrasion of the flexible display screen 11 by the sealing member 13 is reduced.

In some embodiments, each carrier 122 includes a straight segment 1226, and the flexible display screen 11 is connected to the straight segment 1226.

Thus, on the one hand, the flexible display screen 11 is wound more flatly when the two carriers 122 gather and come into contact with each other; on the other hand, the flexible display screen 11 is opened to show a flat display surface when the two carriers 122 separate, the related information displayed on the flexible display screen 11 to be viewed by the user will be clearer, improving visual effect of the interface.

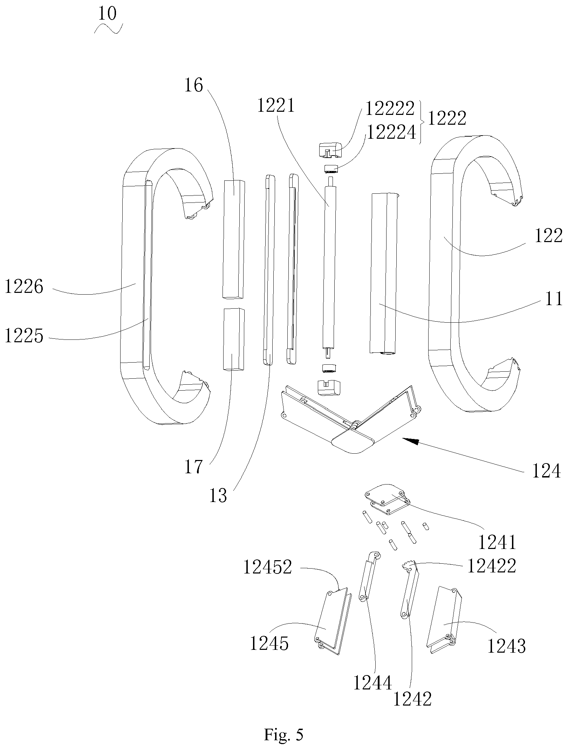

With reference to Fig. 5, in some embodiments, the actuating part 1222 includes a base 12222 fixedly provided in the carrier 122 and a coil spring 12224 connecting the base 12222 and the reel 1221, the reel 1221 is rotatably provided to the base 12222, and the coil spring 12224 is configured to drive the reel 1221 to wind the flexible display screen 11 when the two carriers 122 gather.

Specifically, the coil spring 12224 can continuously provide a relatively great restoring force in a narrow space without using electric power. When the two carriers 122 separate, the connection mechanism 124 for connecting the two carriers is configured to fix the two carriers 122, and the flexible display screen 11 is opened. The coil spring 12224 drives the reel 1221 to wind the flexible display screen 11 when the two carriers 122 gather.

In some embodiments of the present disclosure, two ends of the reel 1221 are each provided with the base 12222 and the coil spring 12224, and the carrier 122 is connected to the two bases 12224 through one coil spring 12224 separately. The two coil springs 12224 simultaneously drive the reel 1221 to wind the flexible display screen 11 when the two carriers 122 gather, such that the flexible display screen 11 can be more easily wound on the reel 1221.

In some embodiments, a length of the reel 1221 is greater than a length L of the flexible display screen 11.

Thus, the process of winding the flexible display screen 11 by the reel 1221 will be smoother, and the flexible display screen 11 will also be wound more flatly.

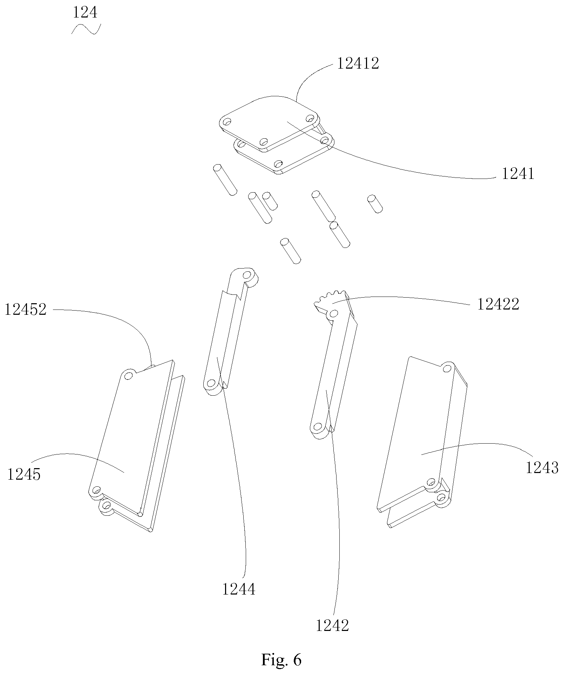

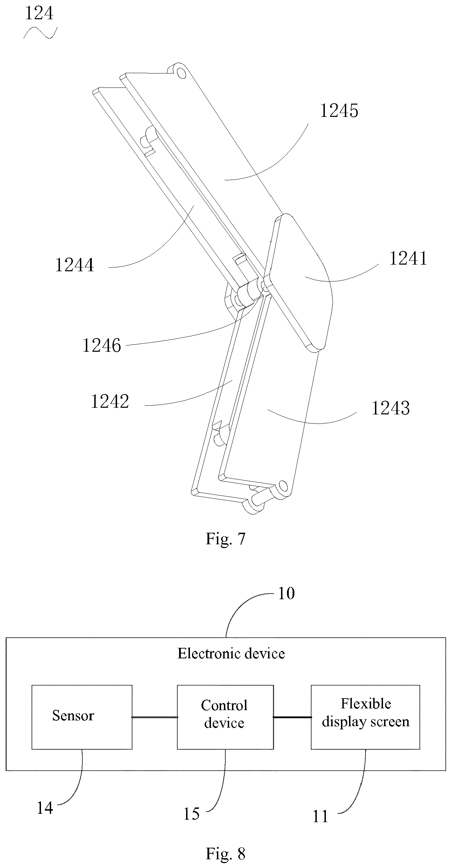

With reference to Figs. 6 and 7, in some embodiments, the connection mechanism 124 includes a first hinge 1241, a second hinge 1242, a third hinge 1243, a fourth hinge 1244 and a fifth hinge 1245. The second hinge 1242 and the third hinge 1243 are connected to a first end of the first hinge 1241. The second hinge 1242 includes a first gear 12422. The third hinge 1243 has an end connected to one carrier 122. The fourth hinge 1244 and the fifth hinge 1245 are connected to a second end of the first hinge 1241. The fifth hinge 1245 includes a second gear 12452. The fifth hinge 1245 has an end connected to the other carrier 122. The second hinge 1242 and the fifth hinge 1245 are connected by engagement between the first gear 12422 and the second gear 12452.

Specifically, when the two carriers gather or unfolded, by means of the engagement of the gears of the second hinge 1242 and the fifth hinge 1245, the one carrier 122 connected to the end of the third hinge 1243 and the other carrier 122 connected to the fifth hinge 1245 form a linkage, and rotate around a rotary shaft 1246. That is, the two carriers 122 can be simultaneously folded or moved apart in opposite directions.

Thus, the operation is more convenient, and the user experience is improved.

In addition, in embodiments of the present disclosure, the first hinge 1241 may also be configured to restrict an open angle of the connection mechanism 124. Specifically, the first hinge 1241 includes a V-shaped baffle 12412, one arm of the V-shaped baffle 12412 abuts against an outer side surface of the fifth hinge 1245, and the other arm of the V-shaped baffle 12412 abuts against an outer side surface of the third hinge 1243 to restrict the open angle of the connection mechanism 124.

Thus, the V-shaped baffle 12412 restricts the open angle between the fifth hinge 1245 and the third hinge 1243, and further restricts the open angle of the connection mechanism 124, thereby protecting the flexible display screen 11.

In embodiments of the present disclosure, two connection mechanisms 124 are provided. One connection mechanism 124 is connected to two ends of the two carriers 122, and the other connection mechanism 124 is connected to the other two ends of the two carriers 122. Thus, the connection mechanism 124 can provide an even supporting force for the two carriers 122.

With reference to Fig. 8, in some embodiments, the electronic device 100 includes a sensor 14 and a control device 15. The sensor 14 is configured to detect whether the two carriers 124 separate, and the control device 15 is configured to control the flexible display screen 11 to display in full screen when the two carriers 122 separate.

Thus, when the sensor 14 detects that the two carriers 122 separate, the control device 15 will control the flexible display screen 11 to turn on, and the user does not need to tap a button or a screen, such that the operation becomes more convenient.

In some embodiments, the sensor 14 includes a photoelectric switch.

Specifically, the photoelectric switch is provided at a predetermined position in the receiving cavity 1224 of the carrier 122. When the two carriers 122 gather and come into contact with each other, the photoelectric switch cannot detect light and assumes a normally open state. When the two carriers 122 separate, the photoelectric switch receives the light, and converts an optical signal into an electric signal to achieve the closure of the photoelectric switch, thereby rendering the control device 15 to control the flexible display screen 11 to display in full screen.

Certainly, the form of the sensor 14 is not limited by the above-described embodiments, the sensor 14 can be designed in other forms in other embodiments according to requirements.

In some embodiments, the electronic device 10 includes a battery 16 disposed in the receiving cavity 1224, and the battery 16 is electrically connected to the flexible display screen 11.

Thus, various electronic elements included in the flexible display screen 11 can be powered by the battery 16 to ensure the normal operation of the electronic device 10.

Specifically, the battery 16 may be a rechargeable battery, such as a rechargeable lithium battery.

In some embodiments, the carrier 122 may be provided with a USB interface. The USB interface is electrically connected to the battery 16, and may be configured to connect an external power source to recharge the battery 16 or configured to obtain the date of the electronic device 10.

In some embodiments, the electronic device 10 includes a printed circuit board 17 disposed in the receiving cavity 1224, and the flexible display screen 11 is electrically connected to the printed circuit board 17.

Thus, the printed circuit board 17 (PCB) can provide support and line connection for the various electronic elements included in the flexible display screen 11.

In the description of embodiments of the present disclosure, it is to be understood that terms such as "central," "longitudinal," "lateral," "length," "width," "thickness," "upper," "lower," "front," "rear," "left," "right," "vertical," "horizontal," "top," "bottom," "inner," "outer," "clockwise," and "counterclockwise," should be construed to refer to the orientation as then described or as shown in the drawings under discussion. These relative terms are for convenience of description and do not require that the present disclosure be constructed or operated in a particular orientation. In addition, terms such as "first" and "second" are used herein for purposes of description and are not intended to indicate or imply relative importance or significance. Thus, features limited by "first" and "second" are intended to indicate or imply including one or more than one these features. In the description of embodiments of the present disclosure, "a plurality of' means two or more than two, unless specified otherwise.

In the description of embodiments of the present disclosure, unless specified or limited otherwise, the terms "mounted," "connected," "coupled," and the like are used broadly, and may be, for example, fixed connections, detachable connections, or integral connections; may also be mechanical or electrical connections; may also be direct connections or indirect connections via intervening structures; may also be inner communications of two elements or interactions of two elements. The above terms can be understood by those skilled in the art according to specific situations.

In the description of embodiments of the present disclosure, a structure in which a first feature is "on" or "beneath" a second feature may include an embodiment in which the first feature directly contacts the second feature, and may also include an embodiment in which an additional feature is formed between the first feature and the second feature so that the first feature does not directly contact the second feature, unless otherwise specified. Furthermore, a first feature "on," "above," or "on top of' a second feature may include an embodiment in which the first feature is right "on," "above," or "on top of' the second feature, and may also include an embodiment in which the first feature is not right "on," "above," or "on top of' the second feature, or just means that the first feature has a sea level elevation larger than the sea level elevation of the second feature. While first feature "beneath," "below," or "on bottom of' a second feature may include an embodiment in which the first feature is right "beneath," "below," or "on bottom of' the second feature, and may also include an embodiment in which the first feature is not right "beneath," "below," or "on bottom of' the second feature, or just means that the first feature has a sea level elevation smaller than the sea level elevation of the second feature.

The following disclosure provides many different embodiments or examples to realize different structures of embodiments of the present disclosure. To simplify the disclosure of embodiments of the present disclosure, components and configurations in particular examples are elaborated. Of course, they are illustrative, and are not intended to limit the present disclosure. Moreover, reference numbers and/or letters may be repeated in different examples of the present disclosure for the purpose of simplicity and clarity, which shall not be constructed to indicate the relationships among various embodiments and/or configurations. In addition, embodiments of the present disclosure provide examples of various specific processes and materials, but applicability of other processes and/or utilization of other materials are conceivable for those skilled in the art.

Reference throughout this specification to "an embodiment," "some embodiments," "an illustrative embodiment," "an example," "a specific example," or "some examples," means that a particular feature, structure, material, or characteristic described in connection with the embodiment or example is included in at least one embodiment or example of the present disclosure. Thus, the appearances of the phrases in various places throughout this specification are not necessarily referring to the same embodiment or example of the present application. Furthermore, the particular features, structures, materials, or characteristics may be combined in any suitable manner in one or more embodiments or examples.

Any process or method described in a flow chart or described herein in other ways may be understood to include one or more modules, segments or portions of codes of executable instructions for achieving specific logical functions or steps in the process, and the scope of a preferred embodiment of the present disclosure includes other implementations, in which the functions may be performed not depending on the order shown and discussed, including on a substantially simultaneous manner or in an reverse order according to the related functions, which should be understood by those skilled in the art.

The logic and/or step described in other manners herein or shown in the flow chart, for example, a particular sequence table of executable instructions for realizing the logical function, may be specifically achieved in any computer readable medium to be used by the instruction execution system, device or equipment (such as the system based on computers, the system comprising processors or other systems capable of obtaining the instruction from the instruction execution system, device and equipment and executing the instruction), or to be used in combination with the instruction execution system, device and equipment. As to the specification, "the computer readable medium" may be any device adaptive for including, storing, communicating, propagating or transferring programs to be used by or in combination with the instruction execution system, device or equipment. More specific examples of the computer readable medium comprise but are not limited to: an electronic connection (an electronic device) with one or more wires, a portable computer enclosure (a magnetic device), a random access memory (RAM), a read only memory (ROM), an erasable programmable read-only memory (EPROM or a flash memory), an optical fiber device and a portable compact disk read-only memory (CDROM). In addition, the computer readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the present disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array (PGA), a field programmable gate array (FPGA), etc.

Those skilled in the art shall understand that all or parts of the steps in the above exemplifying method of the present disclosure may be achieved by commanding the related hardware with programs. The programs may be stored in a computer readable storage medium, and the programs comprise one or a combination of the steps in the method embodiments of the present disclosure when run on a computer.

In addition, each function cell of the embodiments of the present disclosure may be integrated in a processing module, or these cells may be separate physical existence, or two or more cells are integrated in a processing module. The integrated module may be realized in a form of hardware or in a form of software function modules. When the integrated module is realized in a form of software function module and is sold or used as a standalone product, the integrated module may be stored in a computer readable storage medium.

The storage medium mentioned above may be read-only memories, magnetic disks, CD, etc.

Although explanatory embodiments of the present disclosure have been shown and described, it would be appreciated by those skilled in the art that the above embodiments are merely exemplary, and cannot be construed to limit the present disclosure, and changes, alternatives, modifications and variations can be made in the embodiments within the scope of the present disclosure.

## Claims

1. An electronic device, comprising:
a flexible display screen; and
a support frame comprising:
two annular carriers, two ends of the flexible display screen being connected to the two carriers respectively, the carrier comprising a reel and an actuating part, the actuating part being configured to drive the reel to wind the flexible display screen when the two carriers gather, the flexible display screen being closed when the two carriers gather and come into contact with each other; and
a connection mechanism for connecting the two carriers, the connection mechanism being configured to fix the two carriers when the two carriers separate, and the flexible display screen being opened when the two carrier separate.

2. The electronic device according to claim 1, wherein each carrier comprises a surface facing the other carrier, and defines a receiving cavity therein and an opening located in the surface and communicated with the receiving cavity, the flexible display screen passes through the two openings, the reel and the actuating part are received in the receiving cavity, and the two surface are attached to each other when the two carriers gather and come into contact with each other.

3. The electronic device according to claim 2, wherein the electronic device comprises a sealing member, the sealing member is disposed in the opening and defines a via hole together with an inner wall of the opening, and the flexible display screen passes through the via hole.

4. The electronic device according to claim 3, wherein the sealing member is made of soft materials, and the flexible display screen is in contact with the sealing member.

5. The electronic device according to claim 1, wherein each carrier comprises a straight segment, and the flexible display screen is connected to the straight segment.

6. The electronic device according to claim 1, wherein the actuating part comprises a base fixedly disposed in the carrier and a coil spring connecting the base with the reel, the reel is rotatably disposed to the base, and the coil spring is configured to drive the reel to wind the flexible display screen when the two carriers gather.

7. The electronic device according to claim 6, wherein a length of the reel is greater than a length of the flexible display screen.

8. The electronic device according to claim 1, wherein the connection mechanism comprises:
a first hinge;
a second hinge and a third hinge both connected to a first end of the first hinge, the second hinge comprising a first gear, an end of the third hinge being connected to one of the carriers; and
a fourth hinge and a fifth hinge both connected to a second end of the first hinge, the fifth hinge comprising a second gear, an end of the fifth hinge being connected to the other of the carriers,
wherein the second hinge and the fifth hinge are connected by engagement between the first gear and the second gear.

9. The electronic device according to claim 1, wherein the electronic device comprises a sensor and a control device, the sensor is configured to detect that whether the two carriers separate, and the control device is configured to control the flexible display screen to display in full screen when the two carriers separate.

10. The electronic device according to claim 9, wherein the sensor comprises a photoelectric switch.

11. The electronic device according to claim 2, wherein the electronic device comprises a battery disposed in the receiving cavity, and the battery is electrically connected to the flexible display screen.

12. The electronic device according to claim 2, wherein the electronic device comprises a printed circuit board disposed in the receiving cavity, and the flexible display screen is electrically connected to the printed circuit board.

13. The electronic device according to claim 8, wherein the first hinge comprises a V-shaped baffle, one arm of the V-shaped baffle abuts against an outer side surface of the fifth hinge, and the other arm of the V-shaped baffle abuts against an outer side surface of the third hinge to restrict an open angle of the connection mechanism.
